# FASCICULE DE BREVET EUROPEEN

(11) **EP 3 404 506 B1**
(45) Date de publication et mention de la délivrance du brevet: **18.03.2020**
(21) Numéro de dépôt: 18169727.7
(22) Date de dépôt: 27.04.2018
(51) Int. Cl.: G05G 1/02, B60K 35/00, B60K 37/02, B25J 13/08, H01H 3/12, H03K 17/96, H01H 13/14, H01H 13/02

(54) **PANNEAU DE COMMANDE POUR VEHICULE AUTOMOBILE**
BEDIENUNGSFELD FÜR KRAFTFAHRZEUG
CONTROL PANEL FOR A MOTOR VEHICLE

(30) Priorité: 18.05.2017 FR 1754424
(43) Date de publication de la demande: 21.11.2018
(73) Titulaire: Aptiv Technologies Limited, St. Michael (BB)
(72) Inventeur: POLAK, Andrzej, 50354 HUERTH (DE)
(74) Mandataire: Vigand, Philippe

(56) Documents cités:
- WO-A1-2013/168721
- DE-C1- 19 964 166
- US-A1- 2009 173 613
- US-A1- 2010 314 229

## Description

### DOMAINE TECHNIQUE

La présente invention concerne un panneau de commande pour véhicule automobile et plus particulièrement les touches de commande d'un tel panneau.

### ARRIERE-PLAN TECHNOLOGIQUE DE L'INVENTION

Les occupants d'une automobile sont très sensibles à l'aspect visuel et au toucher des touches de commande d'un panneau de commande.

DE 199 64 166 C1 divulgue un élément de commande électronique utilisé dans des véhicules comprenant un support, une carte à circuit imprimé qui est fixée sur le support, un élément de façade qui est monté sur le support et qui recouvre la carte à circuit imprimé, l'élément de façade comprenant au moins une touche de commande actionnable qui est venue de matière avec une partie fixe de l'élément de façade et qui s'étend au-dessus d'une zone de la carte à circuit imprimé, la touche de commande comportant une extrémité de jonction avec la partie fixe de l'élément de façade et une extrémité libre mobile.

Généralement une touche de commande comprend un capuchon fixé dans des éléments de guidage qui peuvent se déplacer le long d'éléments de guidage dans un boîtier. La surface extérieure de ce capuchon est généralement peinte et le symbole graphique est gravé au laser. Un élément de guidage est fabriqué en plastique en tant que partie séparée et le capuchon lui est monté à l'aide de caractéristiques d'écrêtage. L'assemblage est guidé dans le boîtier grâce à des paliers à glissement ou à rotation. Pour améliorer les retours tactiles et réduire le risque de touche de commande bloquée, de la graisse est souvent distribuée sur les surfaces de glissement afin de réduire les frottements glissants. Lorsqu'elle est poussée par un utilisateur, la touche de commande fournit une entrée dans le sens d'activation à un micro-interrupteur pour créer l'état repos / activé.

Les panneaux de commande équipés de telles touches de commande sont généralement encombrants et complexes à fabriquer.

Il est donc important de proposer une solution nouvelle résolvant ces problèmes.

### RESUME DE L'INVENTION

Un panneau de commande pour véhicule automobile comprend un support, une carte à circuit imprimé qui est fixée sur le support, un élément de façade qui est monté sur le support et qui recouvre la carte à circuit imprimé; l'élément de façade comprenant au moins une touche de commande actionnable qui est venue de matière avec une partie fixe de l'élément de façade et qui s'étend au-dessus d'une zone de la carte à circuit imprimé; la touche de commande comportant une extrémité de jonction avec la partie fixe de l'élément de façade et une extrémité libre mobile. La touche de commande comporte à son extrémité de jonction une première protubérance en appui contre le support et/ou contre la carte à circuit imprimé, et comporte à son extrémité libre une zone d'appui prévue pour être touchée par un opérateur en vue d'actionner la touche de commande ; la touche de commande comporte également une seconde protubérance agencée entre la première protubérance et la zone d'appui, ladite seconde protubérance étant de hauteur inférieure à la première protubérance et comportant à son extrémité libre en vis-à-vis de la carte à circuit imprimé une surface d'appui prévue pour venir en contact avec un capteur agencé en vis-à-vis sur la carte à circuit imprimé lorsque la touche de commande est actionnée.

La réalisation de touches de commande venues de matière dans le panneau de commande et d'une structure de touches de commande comparable à un bras de levier est une solution simple et efficace pour permettre la fabrication d'un panneau de commande de faible épaisseur.

La carte à circuit imprimé peut comporter une découpe formant une languette élastique sur laquelle est agencé le capteur. Le support peut comporter un bossage agencé en appui contre la carte à circuit imprimé et agencé sous le capteur. La touche de commande peut comprendre une zone d'épaisseur réduite entre la première protubérance et la seconde protubérance de sorte à faciliter la flexion de la zone d'appui lorsque la touche de commande est actionnée. La zone d'épaisseur réduite peut comprendre un profil d'épaisseur décroissante depuis la seconde protubérance vers la première protubérance.

Une source de lumière peut être agencée sur la carte à circuit imprimé en vis-à-vis de la zone d'appui et une cavité formant guide de lumière peut être agencée dans l'épaisseur de la touche de commande sous la zone d'appui de sorte à pouvoir éclairer un pictogramme agencé sur la zone d'appui.

La touche de commande peut comprendre une troisième protubérance agencée sous l'extrémité libre de la touche de commande et ayant son extrémité libre distante de la carte à circuit imprimé de sorte à former une butée d'arrêt contre la carte à circuit imprimé lorsque la touche de commande est actionnée.

Un élément de détection capacitive élastique peut être agencé intercalé entre la zone d'appui de la touche de commande et la carte à circuit imprimé, l'élément de détection capacitive élastique étant agencé au contact de la touche de commande et raccordé électriquement à la carte à circuit imprimé de sorte à détecter un effleurement de la touche de commande par un opérateur. Le capteur peut être un capteur de force agencé au contact de la surface d'appui de la seconde protubérance. Le capteur de force peut être à la fois un capteur tactile et un actionneur haptique.

L'élément de façade peut comprendre une pluralité de touches de commande alignées bord à bord consécutivement l'une après l'autre de sorte que leurs extrémités de jonction sont alignées de manière rectiligne entre elles et que leurs extrémités libres sont alignées de manière rectiligne entre elles ; et deux touches de commande consécutives peuvent être séparées par un évidement de l'élément de façade s'étendant depuis leurs extrémités libres jusque leurs extrémités de jonctions.

L'élément de façade peut comprendre une pluralité de touches de commande alignées bord à bord consécutivement l'une après l'autre de sorte que leurs extrémités de jonction sont alignées de manière rectiligne entre elles et que leurs extrémités libres sont alignées de manière rectiligne entre elles ; et deux touches de commande consécutives peuvent être séparées par une rainure de l'élément de façade s'étendant depuis leurs extrémités libres jusque leurs extrémités de jonctions.

Un module électronique de plafond d'habitacle de véhicule automobile peut comprendre le panneau de commande décrit ci-dessus.

D'autres buts et avantages de la présente invention apparaîtront au vu de la description qui suit.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique partielle en perspective et en coupe transversale d'un panneau de commande selon l'invention dont deux touches de commande ont été représentées.
- La figure 2 est une vue schématique éclatée en perspective de la figure 1.
- La figure 3 est une vue schématique d'un module électronique de plafond de véhicule comprenant le panneau de commande de la figure 1 équipé de trois touches de commande.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale. Des orientations « gauche », « droite » et « latérale » sont définies selon la direction transversale. Des orientations « avant » et « arrière » sont également définies selon la direction longitudinale.

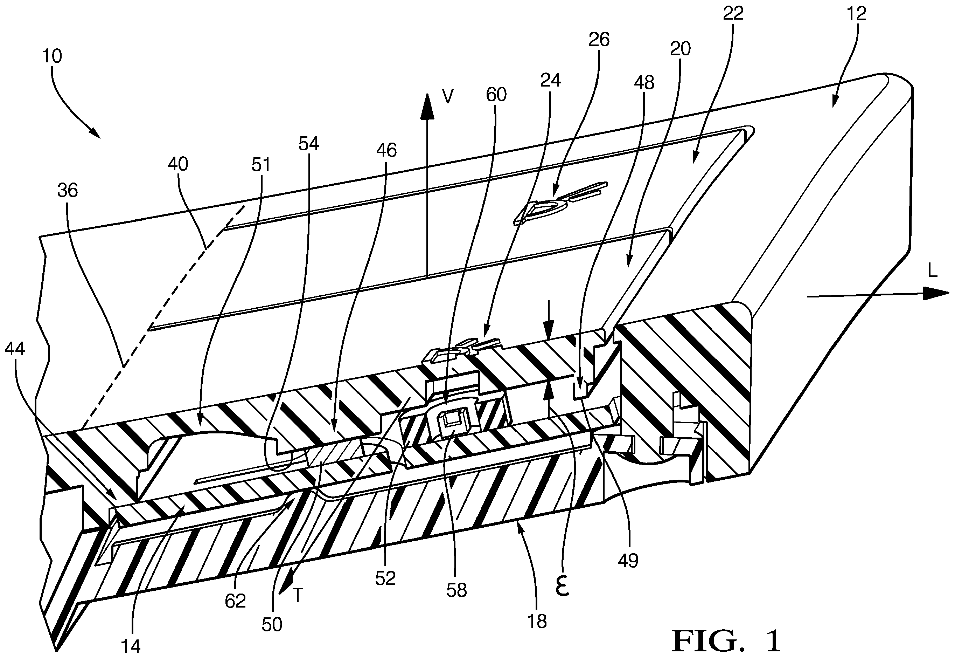

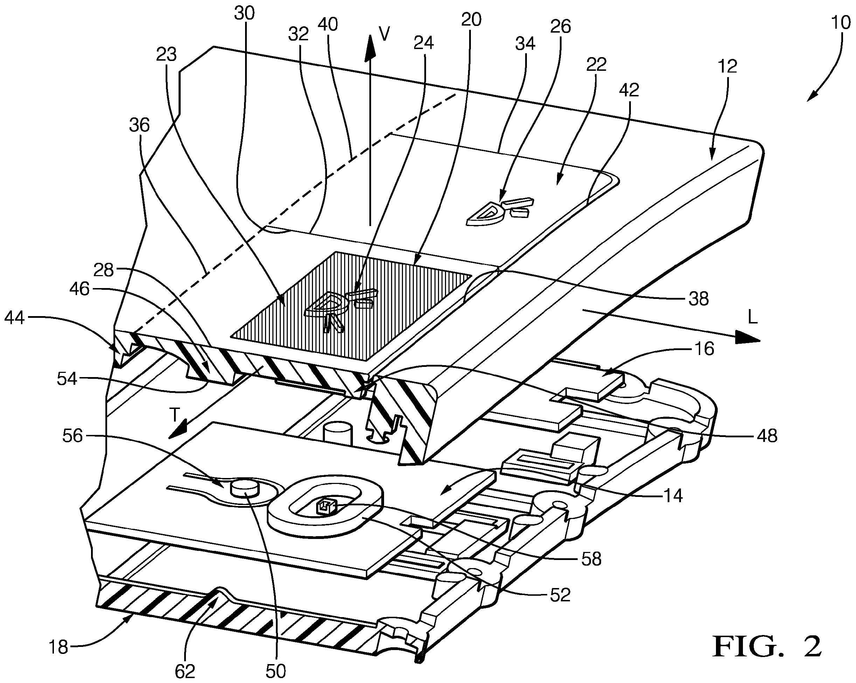

Selon la figure 1 et la figure 2, un panneau de commande 10 pour véhicule automobile comprend un élément de façade 12 accessible à un opérateur, des cartes à circuit imprimé 14, 16 et un support 18 sur lequel les cartes à circuit imprimé 14, 16 sont fixées. Globalement, l'élément de façade 12 est équipé de touches de commandes 20, 22 sous lesquelles sont agencées les cartes à circuit imprimés 14, 16. Une des touches de commande 20 de la figure 1 a été volontairement coupée de sorte à bien distinguer certains détails du mode de réalisation représenté par la figure 1 et la figure 2.

Les touches de commande 20, 22 du panneau de commande 10 représenté sont des touches de commande 20, 22 actionnables qui sont venues de matière avec une partie fixe de l'élément de façade 12. Chaque touche de commande 20, 22 comprend une zone d'appui 23 matérialisée par la présence d'un pictogramme 24, 26. Les deux touches de commande 20, 22 représentées sont agencées en rangée, c'est-à-dire disposées consécutivement l'une à côté de l'autre selon la direction transversale. Chaque touche de commande 20, 22 est globalement de forme rectangulaire. Chaque touche de commande 20, 22 est délimitée par ses deux bords latéraux 28, 30, 32, 34 et par ses deux bords longitudinaux.

Selon l'invention, les bords latéraux 28, 30, 32, 34 de chaque touche de commande 20, 22 sont délimités par un évidement de matière de l'élément de façade 12. En d'autres termes, les deux touches de commande 20, 22 sont séparées l'une de l'autre par une ouverture longitudinale délimitant leurs bords latéraux adjacents 30, 32. L'autre bord latéral 28, 34 de chaque touche de commande 20, 22 est également délimité par un autre évidement de matière de l'élément de façade 12 formant chacun une autre ouverture longitudinale.

Un des bords longitudinal de chaque touche de commande 20, 22 est en continuité de matière avec l'élément de façade 12. Le bord longitudinal de chaque touche de commande 20, 22 en continuité de matière avec l'élément de façade 12 défini une extrémité de jonction 36, 40 entre la touche de commande 20, 22 et l'élément de façade 12. Les extrémités de jonctions 36, 40 des deux touches de commande 20, 22 sont identifiées sur la figure 2 par des traits en pointillés. L'autre bord longitudinal de chaque touche de commande 20, 22 est délimité par une ouverture transversale. En d'autres termes, l'autre bord longitudinal de chaque touche de commande 20, 22 est non accouplée à l'élément de façade 12. Le bord longitudinal de chaque touche de commande 20, 22 délimité par une ouverture transversale défini une extrémité libre 38, 42 de la touche de commande 20, 22.

Selon la figure 1 et la figure 2, les bords longitudinaux des touches de commandes 20, 22 sont alignés entre eux selon la direction transversale. Plus particulièrement, les extrémités de jonction 36, 40 sont alignées entre elles de manière rectiligne selon la direction transversale et les extrémités libres 38, 42 délimitées par l'ouverture transversale sont également alignées entre elles de manière rectiligne selon la direction transversale.

Le pictogramme 24, 26 de chaque touche de commande 20, 22 est agencé suffisamment proche de l'extrémité libre 38, 42 de chaque touche de commande 20, 22 de sorte que la zone d'appui 23 définie par le pictogramme 24, 26 est une zone limitrophe à l'extrémité libre 38, 42 de chaque touche de commande 20, 22. De par les évidements de matière de l'élément de façade 12 autour de chaque touche de commande 20, 22, un appui sur la zone d'appui 23 d'une touche de commande 20, 22 peut permettre un enfoncement de la touche de commande 20, 22 déclenchant l'activation d'une fonction du véhicule.

De façon alternative, l'ouverture longitudinale délimitant les bords latéraux adjacents 30, 32 des deux touches de commande 20, 22 peut être remplacée par une simple rainure longitudinale réalisée par une réduction d'épaisseur de l'élément de façade 12 entre leurs bords latéraux adjacents 30, 32. En d'autre terme, deux touches de commande 20, 22 adjacentes sont reliées entre elles par la rainure. Dans ce cas, l'application d'une force sur la zone d'appui 23 d'une des deux touches de commande 20, 22 entraine également un enfoncement de l'autre touche de commande 20, 22.

L'épaisseur, selon l'axe vertical, de chaque touche de commande 20, 22 n'est pas constante. Chaque touche de commande 20, 22 comporte à son extrémité de jonction 36, 40 une première protubérance 44 en appui contre le support 18 et contre la carte à circuit imprimé 14, 16 agencée sous la touche de commande 20, 22. Chaque touche de commande 20, 22 comporte également une seconde protubérance 46 agencée entre la première protubérance 44 et la zone d'appui 23. Chaque touche de commande 20, 22 comprend de plus une troisième protubérance 48 agencée sous l'extrémité libre de la touche de commande 20, 22 formant une butée d'arrêt contre la carte à circuit imprimé 14, 16 lorsque la touche de commande 20, 22 est actionnée.

La première protubérance 44 s'étend transversalement tout le long de l'extrémité de jonction 36, 40 de la touche de commande 20, 22. La première protubérance 44 permet à la touche de commande 20, 22 d'agir comme un levier. La première protubérance 44 sert de point d'appui du levier formé par la touche de commande 20, 22. La section de la touche de commande 20, 22 comprise entre la première protubérance 44 et l'extrémité libre 38, 40 de la touche de commande 20, 22 forme un bras de levier.

Selon le mode de réalisation représenté, la première protubérance 44 permet également de maintenir la carte à circuit imprimé 14, 16 contre le support 18. De façon alternative, la première protubérance 44 peut ne venir en appui que contre le support 18, la carte à circuit imprimé 14, 16 étant maintenue sur le support 18 par d'autres moyens tels que par exemple par des pions de maintien venus de matière avec le support et permettant le maintien de la carte à circuit imprimé 14, 16.

La seconde protubérance 46 comporte à son extrémité libre en vis-à-vis de la carte à circuit imprimé 14, 16 une surface d'appui 54 en contact avec un capteur de force 50 agencé en vis-à-vis sur la carte à circuit imprimé 14, 16. Lorsque la touche de commande 20, 22 n'est pas sollicitée, c'est-à-dire lorsque la touche de commande 20, 22 est dans un état de repos, le capteur de force 50 n'est soumis à aucune sollicitation autre que l'appui naturel de la touche de commande 20, 22. Lorsque la touche de commande 20, 22 est sollicitée par un opérateur exerçant une force d'enfoncement de la zone d'appui 23, c'est-à-dire lorsque la touche de commande 20, 22 est dans un état actionné, le capteur de force 50 est sollicité et peut transmettre une information de force d'appui à une unité de traitement (non représentée).

Afin d'accentuer la sollicitation du capteur de force 50, la première protubérance 44, c'est-à-dire le point d'appui de la touche de commande 20, 22, peut n'être en appui que contre la carte à circuit imprimé 14, 16.

La troisième protubérance 48 s'étend transversalement tout le long de l'extrémité libre 38, 42 de la touche de commande 20, 22. La troisième protubérance 48 comprend une extrémité libre 49 distante de la carte à circuit imprimé 14, 16. La distance entre l'extrémité libre 49 de la troisième protubérance 48 de la touche de commande 20, 22 définie la profondeur d'appui possible de la touche de commande 20, 22. En d'autre terme, la hauteur, selon l'axe vertical, de la troisième protubérance 48 peut être ajustée de sorte à obtenir le débattement voulue de la touche de commande 20, 22.

Les trois protubérances 44, 46, 48 sont venues de matières avec la touche de commande 20, 22.

La touche de commande 20, 22 comprend une zone d'épaisseur réduite 51 entre la première protubérance 44 et la seconde protubérance 46 de sorte à faciliter la flexion de la zone d'appui 23 lorsque la touche de commande 20, 22 est actionnée. Plus particulièrement, selon le mode de réalisation représenté, la zone d'épaisseur réduite 51 comprend un profil d'épaisseur décroissante depuis la seconde protubérance 46 vers la première protubérance 44. En d'autres termes, l'épaisseur la plus faible de la touche de commande 20, 22 est localisée au plus proche de la première protubérance 44 permettant ainsi de localiser la flexion de la touche de commande 20, 22 lors de son activation au point d'appui. Egalement, ce profil permet de renforcer la rigidité de la seconde protubérance 46 de la touche de commande 20, 22 afin de pouvoir exercer de façon la plus uniforme possible une force d'appui sur le capteur de force 50 lors de l'activation de la touche de commande 20, 22.

Selon la figure 2, chaque carte à circuit imprimé 14, 16 est agencée sous une touche de commande 20, 22. Il est cependant possible de remplacer les deux cartes à circuit imprimé 14, 16 représentées par une seule et unique carte à circuit imprimé.

Selon la figure 1 et la figure 2, le capteur de force 50 agencé sur chaque carte à circuit imprimé 14, 16 est un capteur de type piézoélectrique agencé au contact de la surface d'appui 54 de la seconde protubérance 46. Le capteur piézoélectrique est utilisé comme un capteur de force combinant les propriétés de capteur tactile et d'actionneur haptique. Cet agencement, lorsque la touche de commande 20, 22 est dans un état de repos, permet de pouvoir appliquer au capteur piézoélectrique un signal électrique afin de faire vibrer la touche de commande 20, 22, notamment pour générer un retour de force sur la touche servant d'acquittement perceptible sur la touche de commande 20, 22 par un opérateur suite à l'activation de la touche.

D'autres capteurs de force 50 peuvent être envisagés. Des capteurs n'étant pas en un appui permanant contre la seconde protubérance 46 et donc limitant le capteur à un rôle de déclenchement de fonction du véhicule mais ne permettant pas un acquittement par retour de force sont envisageables. Dans ce cas, de simple capteurs de contact sont également envisageables.

Selon le mode réalisation représenté, chaque carte à circuit imprimé 14, 16 comprend une découpe formant une languette 56 élastique sur laquelle est agencé chaque capteur de force 50. L'élasticité de la languette 56 permet de limiter la pression exercée par un opérateur sur le capteur de force 50 de sorte de le protéger contre une force de pression trop importante détériorant le capteur de force 50. L'élasticité de la languette 56 permet également, selon le positionnement du capteur de force 50 sur la languette 56, d'ajuster la sensibilité de détection du capteur de force 50. Il est à noter que la seconde protubérance 46 s'étend seulement au-dessus de la languette 56 et non pas au-dessus de la partie de la carte à circuit imprimé 14, 16 hors languette de manière à ne pas venir en butée sur la partie de la carte à circuit imprimé 14, 16 hors languette lors de l'activation de la touche de commande 20, 22 par un opérateur.

Avantageusement, en plus du capteur de force 50, chaque carte à circuit imprimé 14, 16 est équipée d'un élément de détection capacitive 52 agencé sous la zone d'appui 23 de chaque touche de commande 20, 22. L'élément de détection capacitive 52 est de type élastique déformable. Selon le mode de réalisation, l'élément de détection capacitive 52 est de forme annulaire s'étendant globalement sous la zone d'appui 23. Il est bien sur possible d'agencer un élément de détection capacitive de forme différente, l'important est de pouvoir couvrir au mieux la zone d'appui 23. Il peut s'agir d'un élastomère chargé de particules métalliques. L'élément de détection capacitive 52 est agencé au contact de la zone d'appui 23 de la touche de commande 20, 22 et est relié électriquement à la carte à circuit imprimé 14, 16. L'élément de détection capacitive 52 peut permettre une présélection d'une fonction associée à la touche de commande 20, 22 lors d'un effleurement de la touche de commande 20, 22 par un opérateur.

L'agencement d'un élément de détection capacitive 52 sous chaque touche de commande 20, 22 peut s'avérer également particulièrement utile lorsque les touches de commandes 20, 22 sont agencées alignées en rangée et que leurs bords latéraux adjacents 30, 32 sont délimités par une rainure. Selon ce mode de réalisation les touches de commande 20, 22 d'une même rangée s'enfoncent toutes ensembles lors d'un appui sur une des touches de commande 20, 22. Dans ce cas de figure, il est possible d'agencer un seul capteur de force 50 sous la surface d'appui 54 d'une seule seconde protubérance 46 d'une seule touche de commande 20. L'unique capteur de force 50 détecte un appui sur l'une quelconque des touches de commande 20, 22 de la rangée de touche de commande 20, 22. L'action sur le capteur de force 50 permet de déclencher une fonction du véhicule associée à la zone d'appui 23 activée et détectée par l'élément de détection capacitive 52.

Egalement, avantageusement, chaque carte à circuit imprimé 14, 16 comporte une source de lumière 58 prévue pour éclairer le pictogramme 24, 26 de chaque touche de commande 20, 22. Selon le mode réalisation représenté, la source de lumière 58 est agencé en vis-à-vis du pictogramme 24, 26 à éclairer. La source de lumière 58 est donc entourée par l'élément de détection capacitive 52. Afin de concentrer le faisceau lumineux de la source de lumière 58, une cavité 60 formant un guide de lumière est agencée dans l'épaisseur ε de la touche de commande 20, 22 sous la zone d'appui 23.

Selon la figure 1 et la figure 2, afin assurer une répartition uniforme de la pression sur le capteur pendant l'activation de chaque touche de commande 20, 22, le support 18 comporte un bossage 62 sur lequel repose la zone de circuit imprimé 14, 16 sur la quelle est agencé le capteur de force 50. Plus précisément, selon le mode de réalisation représenté, la languette 56 de chaque carte à circuit imprimé 14, 16 repose sur un bossage 62 du support 18 en dessous du capteur de force 50.

Globalement, un effet technique recherché par un tel assemblage est l'obtention d'un panneau de commande 10 de très faible épaisseur. L'utilisation de matière plastique souple et également de cartes à circuit imprimé 14, 16 flexibles permet une utilisation d'un tel panneau de commande 10 dans de nombreux modules électroniques de commandes de l'habitacle d'un véhicule. On notera plus particulièrement l'utilisation d'un tel panneau de commande 10 pour des modules électroniques de plafond de véhicule généralement destiné à l'éclairage de l'habitacle du véhicule ou encore à l'utilisation d'un tel panneau de commande 10 pour les modules frontaux de commande électronique de véhicule telle que les commandes du dispositif multimédia ou encore de climatisation du véhicule.

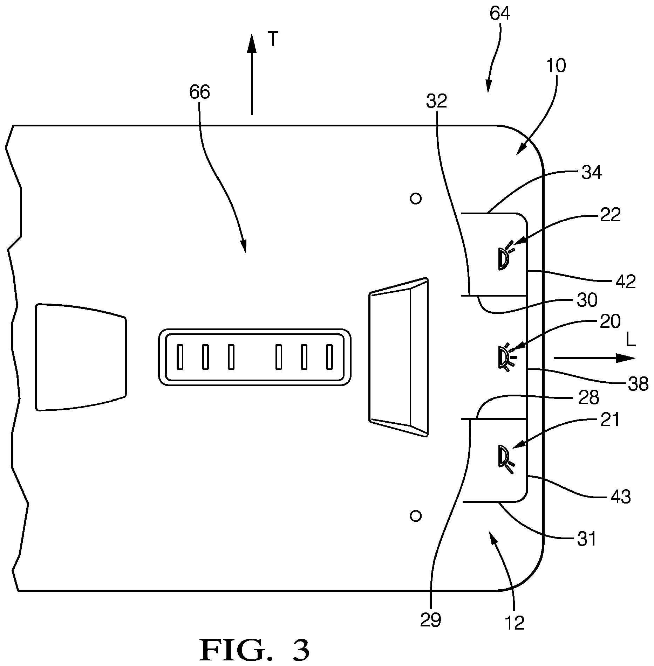

Selon la figure 3, un mode réalisation d'un module électronique de plafond 64 d'habitacle de véhicule est représenté. Ce module est généralement destiné à l'éclairage des places avant du véhicule. Le module électronique de plafond 64 comporte le panneau de commande 10 des figures 1 et 2 représenté complété avec une troisième touche de commande 21. Les trois touches de commande 20, 21, 22 assurent les fonctions d'éclairage de l'habitacle. Le module électronique de plafond 64 comporte également une zone équipée d'éclairage de l'habitacle 66 du véhicule. Brièvement, le panneau de commande 10 comporte les trois touches de commande 20, 21, 22 agencées en rangé selon l'invention. Les trois touches de commande 20, 21, 22 se composent d'une touche de commande centrale 20 comprenant de part et d'autres de ses bords latéraux une première touche latérale 21 d'une part et une seconde touche latérale 22 d'autre part. Les extrémités libres 38, 42, 43 des trois touches de commandes 20, 21, 22 sont non accouplées à l'élément de façade 12 grâce à l'ouverture rectiligne selon la direction transversale de l'élément de façade 12. Cette ouverture rectiligne se prolonge longitudinalement de part et d'autre de la rangée de touche de commande 20, 21, 22, délimitant ainsi les bords transversaux 31, 34 de la première touche latérale 21 et de la seconde touche latérale 22 non adjacents à la touche centrale 20.

Les bords latéraux 28, 30 de la touche de commande centrale 20, sont, selon le mode de réalisation désiré, soit chacun séparés par une ouverture longitudinale des autres bords latéraux 29, 32 de la première et de la seconde touche de commande latérale 21, 22 formant ainsi trois touches de commande 20, 21, 22 indépendante l'une de l'autre, soit chacun séparé par une rainure longitudinale des autres bords latéraux 29, 32 de la première et de la seconde touche latérale 21, 22 formant ainsi un ensemble de trois touches de commande 20, 21, 22 dont l'enfoncement d'une des touches de commande 20 entraine l'enfoncement des deux autres 21, 22. Dans ce dernier cas, l'utilisation d'éléments de détection capacitive 52 sous chaque zone d'appui 23 de chaque touche de commande 20, 21, 22 et l'utilisation d'un seul capteur de force 50 agencé en appui contre une seconde protubérance 46 d'une des trois touches 20, 21, 22 est envisageable.

## Revendications

1. Panneau de commande (10) pour véhicule automobile comprenant
un support (18);
une carte à circuit imprimé (14) qui est fixée sur le support (18);
un élément de façade (12) qui est monté sur le support (18) et qui recouvre la carte à circuit imprimé (14); l'élément de façade (12) comprenant au moins une touche de commande (20) actionnable qui est venue de matière avec une partie fixe de l'élément de façade (12) et qui s'étend au-dessus d'une zone de la carte à circuit imprimé (14) ; la touche de commande (20) comportant une extrémité de jonction (36) avec la partie fixe de l'élément de façade (12) et une extrémité libre (38) mobile ;
**caractérisé en ce que**
la touche de commande (20) comporte à son extrémité de jonction (36) une première protubérance (44) en appui contre le support (18) et/ou contre la carte à circuit imprimé (14), et comporte à son extrémité libre (38) une zone d'appui (23) prévue pour être touchée par un opérateur en vue d'actionner la touche de commande (20);
et **en ce que** la touche de commande (20) comporte également une seconde protubérance (46) agencée entre la première protubérance (44) et la zone d'appui (23), ladite seconde protubérance (46) étant de hauteur inférieure à la première protubérance (44) et comportant à son extrémité libre en vis-à-vis de la carte à circuit imprimé (14) une surface d'appui (54) prévue pour venir en contact avec un capteur (50) agencé en vis-à-vis sur la carte à circuit imprimé (14) lorsque la touche de commande (20) est actionnée.

2. Panneau de commande (10) selon la revendication 1 **caractérisé en ce que** la carte à circuit imprimé (14) comporte une découpe formant une languette élastique (56) sur laquelle est agencé le capteur (50).

3. Panneau de commande (10) selon l'une quelconque des revendications précédentes **caractérisé en ce que** le support (18) comporte un bossage (62) agencé en appui contre la carte à circuit imprimé (14) et agencé sous le capteur (50).

4. Panneau de commande (10) selon l'une quelconque des revendications précédentes, **caractérisé en ce que** la touche de commande (20) comprend une zone d'épaisseur réduite (51) entre la première protubérance (44) et la seconde protubérance (46) de sorte à faciliter la flexion de la zone d'appui (23) lorsque la touche de commande (20) est actionnée.

5. Panneau de commande (10) selon la revendication 4, **caractérisé en ce que** la zone d'épaisseur réduite (51) comprend un profil d'épaisseur décroissante depuis la seconde protubérance (46) vers la première protubérance (44).

6. Panneau de commande (10) selon l'une quelconque des revendications précédentes **caractérisé en ce qu'**une source de lumière (52) est agencée sur la carte à circuit imprimé (14) en vis-à-vis de la zone d'appui (23) et qu'une cavité (60) formant guide de lumière est agencée dans l'épaisseur (ε) de la touche de commande (20) sous la zone d'appui (23) de sorte à pouvoir éclairer un pictogramme (24) agencé sur la zone d'appui (23).

7. Panneau de commande (10) selon l'une quelconque des revendications précédentes, **caractérisé en ce que** la touche de commande (20) comprend une troisième protubérance (48) agencée sous l'extrémité libre (38) de la touche de commande (20) et ayant son extrémité libre distante de la carte à circuit imprimé (14) de sorte à former une butée d'arrêt contre la carte à circuit imprimé (14) lorsque la touche de commande (20) est actionnée.

8. Panneau de commande (10) selon l'une quelconque des revendications précédentes, **caractérisé en ce qu'**un élément de détection capacitive (52) élastique est agencé intercalé entre la zone d'appui (23) de la touche de commande (20) et la carte à circuit imprimé (14), l'élément de détection capacitive (52) élastique étant agencé au contact de la touche de commande (20) et raccordé électriquement à la carte à circuit imprimé (14) de sorte à détecter un effleurement de la touche de commande (20) par un opérateur.

9. Panneau de commande (10) selon l'une quelconque des revendications précédentes, caractérisé en ce le capteur (50) est un capteur de force agencé au contact de la surface d'appui (54) de la seconde protubérance (46).

10. Panneau de commande selon la revendication 9, **caractérisé en ce que** le capteur de force est à la fois un capteur tactile et un actionneur haptique.

11. Panneau de commande (10) selon l'une quelconque des revendications précédentes **caractérisé en ce que** l'élément de façade comprend une pluralité de touches de commande (20, 22) alignées bord à bord consécutivement l'une après l'autre de sorte que leurs extrémités de jonction (36, 40) sont alignées de manière rectiligne entre elles et que leurs extrémités libres (38, 42) sont alignées de manière rectiligne entre elles ; et **en ce que** deux touches de commande (20, 22) consécutives sont séparées par un évidement de l'élément de façade (12) s'étendant depuis leurs extrémités libres(38, 42) jusque leurs extrémités de jonctions (36, 40).

12. Panneau de commande (10) selon l'une quelconque des revendications 1 à 10 **caractérisé en ce que** l'élément de façade (12) comprend une pluralité de touches de commande (20, 22) alignées bord à bord consécutivement l'une après l'autre de sorte que leurs extrémités de jonction (36, 40) sont alignées de manière rectiligne entre elles et que leurs extrémités libres (38, 42) sont alignées de manière rectiligne entre elles ; et **en ce que** deux touches de commande (20, 22) consécutives sont séparées par une rainure de l'élément de façade (12) s'étendant depuis leurs extrémités libres (38, 42) jusque leurs extrémités de jonctions (36, 40).

13. Module électronique de plafond (64) d'habitacle de véhicule automobile comprenant le panneau de commande (10) selon l'une quelconque des revendications précédentes.

## Patentansprüche

1. Bedienungsfeld (10) für Kraftfahrzeuge, das umfasst:
einen Halter (18);
eine gedruckte Leiterplatte (14), die an dem Halter (18) befestigt ist;
ein Außenseitenelement (12), das an dem Halter (18) montiert ist und das die gedruckte Leiterplatte (14) bedeckt; wobei das Außenseitenelement (12) mindestens eine betätigbare Bedienungstaste (20) umfasst, die mit einem festen Teil des Außenseitenelements (12) einstückig ist und die sich über einem Bereich der gedruckten Leiterplatte (14) erstreckt; wobei die Bedienungstaste (20) ein Ende (36) zur Verbindung mit dem festen Teil des Außenseitenelements (12) und ein bewegliches freies Ende (38) umfasst;
**dadurch gekennzeichnet, dass**
die Bedienungstaste (20) an ihrem Verbindungsende (36) eine erste Ausbauchung (44) umfasst, die gegen den Halter (18) und/oder gegen die gedruckte Leiterplatte (14) aufliegt und an ihrem freien Ende (38) einen Drückbereich (23) umfasst, der vorgesehen ist, um von einem Bediener mit dem Ziel des Betätigens der Bedienungstaste (20) berührt zu werden;
und dadurch, dass die Bedienungstaste (20) ebenfalls eine zweite Ausbauchung (46) umfasst, die zwischen der ersten Ausbauchung (44) und dem Drückbereich (23) angeordnet ist, wobei die zweite Ausbauchung (46) eine geringere Höhe als die erste Ausbauchung (44) aufweist und an ihrem freien Ende der gedruckten Leiterplatte (14) gegenüberliegend eine Drückfläche (54) umfasst, die vorgesehen ist, um mit einem der gedruckten Leiterplatte (14) gegenüberliegend angeordneten Sensor (50) in Kontakt zu gelangen, wenn die Bedienungstaste (20) betätigt wird.

2. Bedienungsfeld (10) nach Anspruch 1, **dadurch gekennzeichnet, dass** die gedruckte Leiterplatte (14) einen Ausschnitt umfasst, der eine elastische Zunge (56) bildet, auf der der Sensor (50) angeordnet ist.

3. Bedienungsfeld (10) nach einem der vorhergehenden Ansprüche, **dadurch gekennzeichnet, dass** der Halter (18) einen Höcker (62) umfasst, der in Auflage gegen die gedruckte Leiterplatte (14) angeordnet ist und unter dem Sensor (50) angeordnet ist.

4. Bedienungsfeld (10) nach einem der vorhergehenden Ansprüche, **dadurch gekennzeichnet, dass** die Bedienungstaste (20) einen Bereich (51) mit verringerter Dicke zwischen der ersten Ausbauchung (44) und der zweiten Ausbauchung (46) umfasst, derart, dass die Biegung des Drückbereichs (23), wenn die Bedienungstaste (20) betätigt wird, erleichtert wird.

5. Bedienungsfeld (10) nach Anspruch 4, **dadurch gekennzeichnet, dass** der Bereich (51) mit verringerter Dicke ein Profil mit ausgehend von der zweiten Ausbauchung (46) hin zur ersten Ausbauchung (44) abnehmender Dicke aufweist.

6. Bedienungsfeld (10) nach einem der vorhergehenden Ansprüche, **dadurch gekennzeichnet, dass** eine Lichtquelle (52) auf der gedruckten Leiterplatte (14) dem Drückbereich (23) gegenüberliegend angeordnet ist und dass ein Hohlraum (60), der einen Lichtleiter bildet, in der Dicke (ε) der Bedienungstaste (20) unter dem Drückbereich (23) angeordnet ist, derart, dass ein auf dem Drückbereich (23) angeordnetes Piktogramm (24) beleuchtet werden kann.

7. Bedienungsfeld (10) nach einem der vorhergehenden Ansprüche, **dadurch gekennzeichnet, dass** die Bedienungstaste (20) eine dritte Ausbauchung (48) umfasst, die unter dem freien Ende (38) der Bedienungstaste (20) angeordnet ist und deren freies Ende von der gedruckten Leiterplatte (14) entfernt aufweist, derart, dass ein Anschlag gegen die gedruckte Leiterplatte (14) gebildet wird, wenn die Bedienungstaste (20) betätigt wird.

8. Bedienungsfeld (10) nach einem der vorhergehenden Ansprüche, **dadurch gekennzeichnet, dass** ein elastisches kapazitives Detektionselement (52) zwischen dem Drückbereich (23) der Bedienungstaste (20) und der gedruckten Leiterplatte (14) zwischengestellt angeordnet ist, wobei das elastische kapazitive Detektionselement (52) im Kontakt mit der Bedienungstaste (20) angeordnet und elektrisch an die gedruckte Leiterplatte (14) angeschlossen ist, um ein leichtes Berühren der Bedienungstaste (20) durch einen Bediener zu detektieren.

9. Bedienungsfeld (10) nach einem der vorhergehenden Ansprüche, **dadurch gekennzeichnet, dass** der Sensor (50) ein Kraftsensor ist, der im Kontakt mit der Drückfläche (54) der zweiten Ausbauchung (46) angeordnet ist.

10. Bedienungsfeld nach Anspruch 9, **dadurch gekennzeichnet, dass** der Kraftsensor sowohl ein berührungsempfindlicher Sensor als auch ein haptisches Betätigungsorgan ist.

11. Bedienungsfeld (10) nach einem der vorhergehenden Ansprüche, **dadurch gekennzeichnet, dass** das Außenseitenelement eine Vielzahl von Bedienungstasten (20, 22) umfasst, die derart eine nach der anderen, aufeinanderfolgend Seite an Seite ausgerichtet sind, dass ihre Verbindungsenden (36, 40) geradlinig aufeinander ausgerichtet sind und dass ihre freien Enden (38, 42) geradlinig aufeinander ausgerichtet sind; und dadurch, dass die zwei aufeinanderfolgenden Bedienungstasten (20, 22) von einer Aussparung des Außenseitenelements (12) getrennt sind, die sich von ihren freien Enden (38, 42) bis zu ihren Verbindungsenden (36, 40) erstreckt.

12. Bedienungsfeld (10) nach einem der Ansprüche 1 bis 10, **dadurch gekennzeichnet, dass** das Außenseitenelement (12) eine Vielzahl von Bedienungstasten (20, 22) umfasst, die derart eine nach der anderen, aufeinanderfolgend Seite an Seite ausgerichtet sind, dass ihre Verbindungsenden (36, 40) geradlinig aufeinander ausgerichtet sind und dass ihre freien Enden (38, 42) geradlinig aufeinander ausgerichtet sind; und dadurch, dass zwei aufeinanderfolgende Bedienungstasten (20, 22) von einer Rille des Außenseitenelements (12) getrennt sind, die sich von ihren freien Enden (38, 42) bis zu ihren Verbindungsenden (36, 40) erstreckt.

13. Elektronisches Fahrgastzellendeckenmodul (64) für Kraftfahrzeuge, das das Bedienungsfeld (10) nach einem der vorhergehenden Ansprüche umfasst.

## Claims

1. A control panel (10) for a motor vehicle comprising
a support (18);
a printed circuit board (14) which is fixed on the support (18);
a facade element (12) which is mounted on the support (18) and which covers the printed circuit board (14); the facade element (12) comprising at least one operable control button (20) which is integrally formed with a fixed portion of the facade element (12) and which extends above an area of the printed circuit board (14); the control button (20) including a junction end (36) with the fixed portion of the facade element (12) and a movable free end (38);
**characterized in that**
the control button (20) includes at its junction end (36) a first protrusion (44) bearing against the support (18) and/or against the printed circuit board (14), and includes at its free end (38) a bearing area (23) provided to be touched by an operator in order to operate the control button (20);
and **in that** the control button (20) also includes a second protrusion (46) arranged between the first protrusion (44) and the bearing area (23), said second protrusion (46) being of smaller height than the first protrusion (44) and including at its free end opposite the printed circuit board (14) a bearing surface (54) intended to come into contact with a sensor (50) arranged oppositely on the printed circuit board (14) when the control button (20) is operated.

2. The control panel (10) according to claim 1, **characterized in that** the printed circuit board (14) includes a cutout forming an elastic tab (56) on which the sensor (50) is arranged.

3. The control panel (10) according to any one of the preceding claims, **characterized in that** the support (18) includes a boss (62) arranged bearing against the printed circuit board (14) and arranged under the sensor (50).

4. The control panel (10) according to any one of the preceding claims, **characterized in that** the control button (20) comprises a reduced-thickness area (51) between the first protrusion (44) and the second protrusion (46) so as to facilitate the bending of the bearing area (23) when the control button (20) is operated.

5. The control panel (10) according to claim 4, **characterized in that** the reduced-thickness area (51) comprises a decreasing-thickness profile from the second protrusion (46) to the first protrusion (44).

6. The control panel (10) according to any one of the preceding claims, **characterized in that** a light source (52) is arranged on the printed circuit board (14) opposite the bearing area (23) and **in that** a cavity (60) forming a light guide is arranged in the thickness (ε) of the control button (20) under the bearing area (23) so as to be able to illuminate a pictogram (24) arranged on the bearing area (23).

7. The control panel (10) according to any one of the preceding claims, **characterized in that** the control button (20) comprises a third protrusion (48) arranged under the free end (38) of the control button (20) and having its free end remote from the printed circuit board (14) so as to form a stop against the printed circuit board (14) when the control button (20) is operated.

8. The control panel (10) according to any one of the preceding claims, **characterized in that** an elastic capacitive detection element (52) is arranged interposed between the bearing area (23) of the control button (20) and the printed circuit board (14), the elastic capacitive detection element (52) being arranged in contact with the control button (20) and electrically connected to the printed circuit board (14) so as to detect a light touch of the control button (20) by an operator.

9. The control panel (10) according to any one of the preceding claims, **characterized in that** the sensor (50) is a force sensor arranged at the contact of the bearing surface (54) of the second protrusion (46).

10. The control panel according to claim 9, **characterized in that** the force sensor is both a tactile sensor and a haptic actuator.

11. The control panel (10) according to any one of the preceding claims, **characterized in that** the facade element comprises a plurality of control buttons (20, 22) aligned edge-to-edge consecutively one after the other so that their junction ends (36, 40) are aligned together in a rectilinear manner and that their free ends (38, 42) are aligned together in a rectilinear manner; and **in that** two consecutive control buttons (20, 22) are separated by a recess of the facade element (12) extending from their free ends (38, 42) up to their junction ends (36, 40).

12. The control panel (10) according to any one of claims 1 to 10, **characterized in that** the facade element (12) comprises a plurality of control buttons (20, 22) aligned edge-to-edge consecutively one after the other so that their junction ends (36, 40) are aligned together in a rectilinear manner and that their free ends (38, 42) are aligned together in a rectilinear manner; and **in that** two consecutive control buttons (20, 22) are separated by a groove of the facade element (12) extending from their free ends (38, 42) up to their junction ends (36, 40).

13. An electronic module for the ceiling (64) of a passenger compartment of a motor vehicle comprising the control panel (10) according to any one of the preceding claims.
